# EUROPEAN PATENT APPLICATION

(11) **EP 0 661 808 A2**
(43) Date of publication of application: **05.07.1995**
(21) Application number: 94119370.8
(22) Date of filing: 08.12.1994
(51) Int. Cl.: H03K 3/012

(54) **Digital integrated circuits architecture**

(30) Priority: 30.12.1993 ES 9302723
(71) Applicant: ALCATEL STANDARD ELECTRICA, S.A., E-28045 Madrid (ES); ALCATEL N.V., NL-2288 BH Rijswijk (NL)
(72) Inventor: Sanz Gomez, Rafael, E-28005 Madrid (ES); Ortiz Saenz, Fernando, E-28006 Madrid (ES); Merino Gonzalez, Jose Luis, Mondejar P - 1410, E-19174 Torrejon del Rey (Guadalajara) (ES); Gutierrez Serratosa, Maria del Mar, E-28039 Madrid (ES)
(74) Representative: Pohl, Herbert, Dipl.-Ing

(57) **Abstract**

Specially used for reducing the current consumed by digital integrated circuits. For this, the bistables (B) incorporated in the digital integrated circuit are provided with a clock control input (CNTR) to enable or disable them.

These bistables (B) are grouped into functional blocks (FB1,...,FBn) so that all clock control inputs (CNTR) from the bistables (B) of a given functional block (FB1,...,FBn) receive the same clock control signal (CNTR_1,...,CNTR_n) generated in a states machine (SM) as a function of a finite number of possible states in which it is possible to find the electronic equipment of which the integrated circuit forms part.

It is particularly applicable in integrated circuits that perform multiple tasks during an interval of time in a cyclic manner.

## Description

### OBJECT OF THE INVENTION

This invention concerns a digital integrated circuits architecture that permits a reduction in the current consumed by such circuits, this reduction becoming greater as the working frequency of the Integrated circuit and the periods of inactivity of the different functional blocks that comprise the circuit become greater.

### BACKGROUND TO THE INVENTION

It is well known that as the working frequency of digital integrated circuits increases, so too does the current they consume.

This is because of the process of charging and discharging the input capacitance of the logic gates that form part of the digital integrated circuits and it becomes more obvious the greater the number of signal transitions are, i.e. the greater the clock frequency are.

To reduce the current consumption of integrated circuits, the usual practice is to disable the bistable clock at certain moments, which are when the integrated circuit is inactive or when its outputs are of no relevance for the operation required.

This known practice suppresses unnecessary transitions that would result in a useless flow of current.

Nevertheless this can have drawbacks in the overall operation of the integrated circuit assembly, or result in the design being of increased complexity.

Another well known practice is to reduce the operating frequency of the integrated circuit by means of a frequency divider whereby the integrated circuit is permitted to continue working and does not lose the timing reference as is the case with signals in the form of bursty frames in which, for certain bursts, there is no activity, while in others there is.

Through the application of these techniques, a saving results in the current consumed which, depending on the specific working conditions of the integrated circuit, can be considerable.

However, in certain equipments in which the current consumption is critical, such as extended autonomy cordless terminals, the current consumption, even when reduced, can still be excessive, requiring the consumption to be optimised at the minimum value possible without interfering with the correct operation of the digital integrated circuits.

### TECHNICAL PROBLEM TO BE OVERCOME

Considering the state of the art described above, the technical problem to be overcome rests in achieving an optimum reduction in the current consumed by digital integrated circuits without affecting their working characteristics so that a greater life expectancy is achieved for the batteries of the equipments that incorporate these integrated circuits.

### CHARACTERISATION OF THE INVENTION

To provide a solution to the above problem, in accordance with the invention, it is proposed that the bistables of the integrated circuit in question have a clock control input to be enabled such that when it is in the enable state the integrated circuit is permitted to operate, while when it is in the disable state operation is not permitted and, consequently, the possibility of the output or intermediate states progressing from one level to another is disabled.

To carry out this operation, the invention is also characterised in that the bistables incorporated in the integrated circuit are grouped functionally in blocks, whereby the bistables belonging to each block receive the same dock control signal for the enabling or disabling of each complete block.

These clock control signals are generated in a states machine that determines which blocks are to be activated and which not, as a function of the possible finite states in which it is possible for the integrated circuit to be.

Finally, this invention is also characterised in that the bistables included in the integrated circuit to perform the enabling/disabling function, incorporate a clock input logic gate that receives both the dock signal and the clock control signal, so that at the output of this gate the dock signal is blocked or not, depending on the value of the clock control signal in question.

With the application of the invention proposed in this document it is possible to achieve a more efficient use of the current consumed by the integrated circuit since unnecessary transitions of logic signals are avoided in those parts of the circuit with outputs that are irrelevant for the operation required thereby resulting in savings in the current consumption.

### BRIEF FOOTNOTES TO THE FIGURES

Below is given a description of the invention in greater detail based on the figures attached in which:
- figure 1 shows the internal layout of a D type bistable in accordance with the state of the art,
- figure 2 shows the solution adopted in digital integrated circuits for reducing the current consumption in accordance with the state of the art,
- figure 3 shows the architecture, according to the invention, for reducing the current consumption, and
- figure 4 shows the layout of a bistable, also D type, of the kind used in an integrated circuit according to the invention.

### DESCRIPTION OF THE INVENTION

The evolution of technology now allows extremely complicated integrated circuits to be manufactured which, although permitting very complex functions, draw a considerable current since this depends, in general terms, on the working frequency and transitions in the logic gates and on the charge held by these. This is because of the total capacity presented by the logic gates connected to a preceding stage.

Current technology requires higher and higher working frequencies with designs that are more and more complex, and this leads to prohibitive current consumptions; such is the case of integrated circuits incorporated in cordless telephone terminals fed from their own batteries which otherwise would have extremely short lives.

This leads to the requirement to minimise the current consumption of, among other elements, the integrated circuits included in the terminal.

For this reason, consideration has to be given to the activity of an integrated circuit in determined circumstances like, for example, in digital communications systems with TDMA where the terminal only has to transmit in a single time slot and also receive in a single time slot in each frame, the activities performed by the integrated circuits being only relevant in determined periods of time, depending on the function concerned.

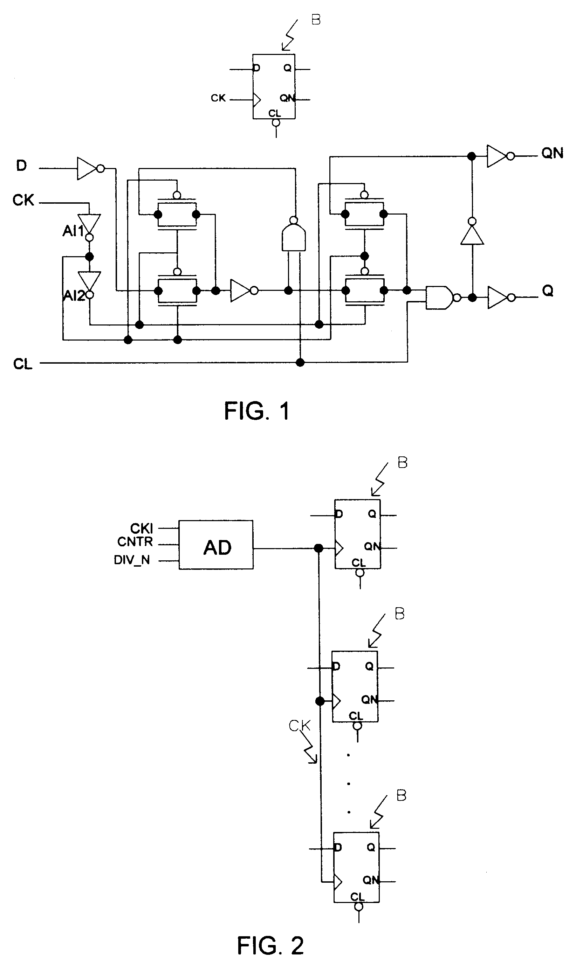

In figure 1 the design can be seen for a typical bistable B from which it may be deduced that a transition at the input D when the activating edge of the clock CK pulse is received, also produces transitions in a determined number of gates that result in a current consumption during the time that the transitions is produced.

Indeed even if there is no change at the input D of the bistable, the inverters AI1 and AI2 located at the clock input CK would be switching at the actual clock frequency and thereby producing a certain current consumption.

Figure 2 shows two possible techniques employed to reduce the current consumption in accordance with the state of the art, by producing either an inhibition of the clock signal CK applied to the bistables B, or a reduction in its frequency. However, in any case, this is not feasible when activity has to be continuously maintained in any part of the integrated circuit.

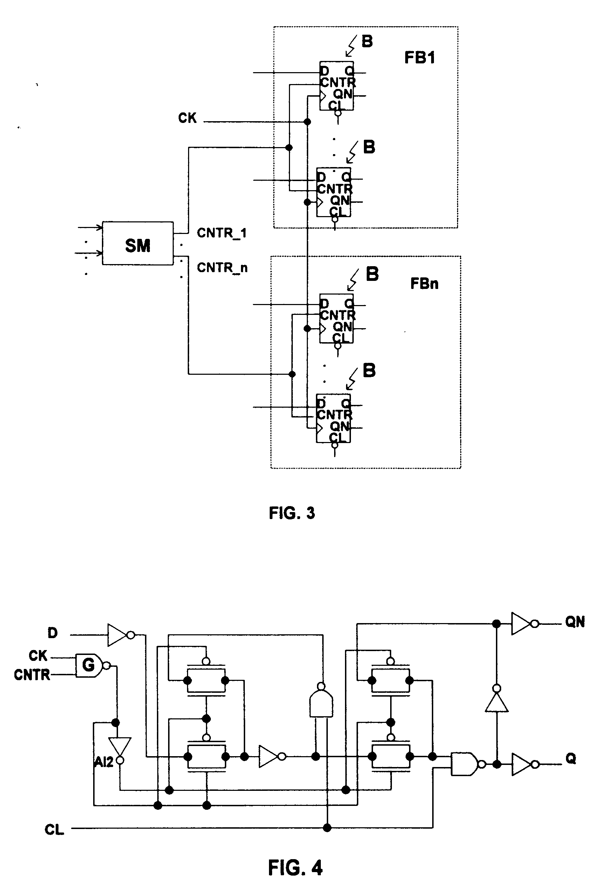

Figure 3, by means of functional blocks, shows the architecture employed in accordance with the invention in order to reduce the current consumption in a digital integrated circuit of the generic type.

In it, the bistables B, that also have a clock control input CNTR, are grouped into functional blocks FB1,...,FBn so that all the bistables in the same functional block receive the same clock control signal CNTR_1,...,CNTR_n, for the enabling or disabling of the complete block.

In order to achieve this, the circuit incorporates a states machine SM which serves to generate the corresponding clock control signals CNTR_1,...,CNTR_n, as a function of the different possible states.

In the case mentioned of cordless terminals with TDMA, there are parts that must always be active, others that only work during the transmit half-frame, others in the receive half-frame, in the time slot of the burst that is being transmitted or received, etc.

In this way the current consumption only occurs in those parts where it is necessary. Nonetheless, a further reduction is achieved in the current consumption if, as indicated in figure 4, clock disabling takes place in the first gate G that receives the clock signal CK.

This figure shows how the first inverter AI1 of figure 1 is replaced by a clock input logic gate G that receives the dock input CK at one of its inputs, the other being the clock control input CNTR that permits blocking of the clock signals from subsequent logic gates. In this way transitions at the output of the first inverter AI1 of figure 1 are prevented from also reaching the second inverter and four additional transistors. It is therefore clear that an extra reduction is achieved in the net current consumption of the circuit.

## Claims

1. **DIGITAL INTEGRATED CIRCUITS ARCHITECTURE** that comprise a set of bistables (B) all of which receive a common clock signal (CK), for the reduction of current consumption **characterised** in that each bistable (B) has a clock control input (CNTR) to permit the operation of the corresponding bistable (B) by enabling or disabling it.

2. **ARCHITECTURE** according to claim 1, **characterised** in that the bistables (B) included in the digital integrated circuit are grouped in a number of functional blocks (FB1,...,FBn) so that all the clock control inputs (CNTR) from every bistable (B) corresponding to the same functional block (FB1,...,FBn) receive the same clock control signal (CNTR_1,...,CNTR_n).

3. **ARCHITECTURE** according to claim 2, **characterised** in that it also incorporates a states machine (SM) that produces the corresponding clock control signals (CNTR_1,...,CNTR_n) for each functional block for the enabling of the clock of the bistables (B) included in the digital integrated circuit.

4. **ARCHITECTURE** according to claim 1, **characterised** in that the bistables (B) contained in the digital integrated circuit and for the enabling/desabling of the clock signal (CK) incorporate a clock input logic gate (G) that receives the clock signal (CK) and the clock control signal (CNTR_1,...,CNTR_n) so that at their outputs the clock signal (CK) applied to the corresponding bistable is or is not blocked, depending on the state of the mentioned clock control signal (CNTR_1,...,CNTR_n).
